# EUROPÄISCHE PATENTSCHRIFT

(11) **EP 0 714 131 B1**
(45) Veröffentlichungstag und Bekanntmachung des Hinweises auf die Patenterteilung: **20.01.1999**
(21) Anmeldenummer: 95117634.6
(22) Anmeldetag: 06.11.1995
(51) Int. Cl.: H01L 25/065

(54) **Anordnung zur induktiven Signalübertragung zwischen den Chiplagen einer vertikal integrierten Schaltung**
Inductive signal transfer device between the chip layers of a vertical integrated circuit
Dispositif de transfert inductif de signaux entre les couches de puce d'un circuit intégré vertical

(30) Priorität: 15.11.1994 DE 4440864
(43) Veröffentlichungstag der Anmeldung: 29.05.1996
(73) Patentinhaber: SIEMENS AKTIENGESELLSCHAFT, 80333 München (DE)
(72) Erfinder: Weber, Werner, Dr., D-80637 München (DE); Kühn, Stefan, D-80545 München (DE); Kleiner, Michael, D-81373 München (DE); Thewes, Roland, D-82178 Puchheim (DE)

(56) Entgegenhaltungen:
- EP-A- 0 073 486
- EP-A- 0 206 696
- DE-A- 2 902 002
- DE-C- 4 314 907
- GB-A- 2 253 308

## Beschreibung

Integrierte Schaltungen werden heute überwiegend in Planartechnik hergestellt. Die erreichbare Komplexität auf einem einzelnen Halbleiterchip ist jedoch begrenzt durch dessen Abmessungen und durch die zu dessen Herstellung verwendete Prozeßtechnologie.

Zur Steigerung der Leistungsfähigkeit werden zur Zeit Ansätze verfolgt, bei denen mehrere Lagen von Halbleiterchips vertikal integriert, d.h. übereinander angeordnet und elektrisch verbunden werden. Bei vertikal integrierten Schaltungen, die im folgenden kurz VICs genannt werden, besteht jeweils eine dreidimensionale Schaltungsstruktur aus einem Stapel unabhängig voneinander prozessierter Einzelchiplagen, die in der Regel mit Klebeschichten verbunden werden. Die einzelnen Chiplagen können dazu vor dem Zusammenbau auf eine entsprechende Dicke "heruntergedünnt", d. h. heruntergeätzt oder heruntergeschliffen werden, um gute elektrische Eigenschaften der vertikalen Verbindungen und eine hohe Verbindungsdichte zu gewährleisten. Bei SOI-Technologien (Silcon on Insulator) bietet sich das vergrabene Oxid als Ätzstop für das "Dünnen" der Scheiben an. Bei konventionellen Silizium-Technologien kann das Substrat bis zum Feldoxid von in einer Chiplage enthaltenen MOSFETs heruntergedünnt sein oder aber noch eine wenige µm dicke Substratschicht an der Unterseite der Chiplagen aufweisen.

Aus der Veröffentlichung Williams R., Marsh O., "Future WSI technology: stacked monolithic WSI", IEEE Transactions on CHMT, vol. 16, No.7, pp.610-614. ist beispielsweise eine Anordnung zur galvanischen Signalübertragung zwischen den Chiplagen einer vertikal integrierten Schaltung bekannt. Dabei sind relativ dünne Chiplagen mit einer Dicke von ca. 10 µm und feine metallische Verbindungen mit einem Durchmesser von ca. 1 µm erforderlich, um, insbesondere bei hohen Verbindungsdichten, gute elektrische Eigenschaften der vertikalen Signalverbindungen zu gewährleisten. Ein wesentlicher Nachteil besteht hierbei jedoch darin, daß extrem hohe Anforderungen an die Justierung der Chiplagen zueinander und an die Planarität der Chipoberflächen zu stellen sind.

In jüngerer Zeit wurden deshalb, beispielsweise in der Veröffentlichung Val C., Leroy M., "The 3D interconnection - applications for mass memories and microprocessors", Proc. 24th Symp. on ISHM, 1991, pp.62-68, Anordnungen vorgeschlagen, bei denen die Verbindungen von Chiplage zu Chiplage über die Seitenflächen geführt werden, dies birgt jedoch den Nachteil, daß die vertikalen Verbindungen zum einen nicht frei plazierbar und zum anderen um Größenordnungen länger sind als bei den obengenannten VICs.

Aus der deutschen Offenlegungsschrift 29 02 002 ist eine dreidimensional integrierte Schaltung bekannt, bei der Energie und/oder Signale zwischen Scheiben kapazitiv oder induktiv übertragen werden.

Die der Erfindung zugrundeliegende Aufgabe liegt nun darin, eine Anordnung zur Signalübertragung zwischen den Chiplagen einer vertikal integrierten Schaltung anzugeben, bei der eine groBe Anzahl frei plazierbarer und zuverlässiger vertikaler Signalverbindungen direkt vom Inneren einer Chiplage zum Inneren einer benachbarten Chiplage bestehen, obwohl diese Anordnung ohne extrem hohe Anforderungen an die Justierung der Chiplagen zueinander und an die Planarität der Chipoberflächen herzustellen ist und bei der eine Sendeeinrichtung und eine Empfangseinrichtung so ausgelegt werden können, daB relativ groBe Variationen der Koppelinduktivitat und auch gewisse induktive Einkopplungen von Störgrößen toleriert werden können, wodurch die Signalübertragung auch dann sicher funktioniert, wenn zum Beispiel Oberflächenwelligkeiten der Chiplagen und UnregelmäBigkeiten der Klebeschicht zwischen den Chiplagen den Abstand der Spulen und damit die Koppelinduktivitat verändern oder bei großen Abständen relativ starke Störung durch Einkopplungen erfolgt.

Diese Aufgabe wird erfindungsgemäß durch die im Patentanspruch 1 angegebenen Merkmale gelöst.

Die mit der Erfindung erzielten Vorteile liegen insbesondere darin,
daß, bei entsprechender Dimensionierung der Sendeeinrichtung, der Empfangseinrichtung und der Koppelinduktivität, eine sichere Signalübertragung auch zwischen nicht direkt benachbarten Chiplagen gewährleistet wird, daß die induktive Signalübertragung die Auswertung eines Sendesignals durch verschiedene Empfangseinrichtungen in verschiedenen Chiplagen ermöglicht, was beispielsweise die Verteilung von Takten oder Bussignalen erleichtert, daß die Spulen durch geeignete Anordnung tolerant gegenüber etwaigen lateralen Versatzen der Chiplagen ausgelegt werden können, daß die Sende- und Empfangseinrichtungen direkt ein kontaktloses Testen einzelner Chiplagen durch Verwendung von Adapterstrukturen ermöglichen und daß innovative und aufwendige ProzeBschritte zur Herstellung von galvanischen Verbindungen zwischen den Chiplagen bei der kontaktlosen Signalübertragung vermieden werden können.

Ferner weist eine induktive Signalübertragung die Vorteile auf, daß eine Transmission der Information durch nahezu alle in der IC-Prozeßtechnik gebräuchlichen Materialien möglich ist, was die Herstellung der vertikalen Kontakte beträchtlich vereinfacht. Im Gegensatz dazu können bei Anordnungen zur galvanischen Signalübertragung zwischen Chiplagen eines VICs das Probleme dadurch auftreten, daB die übertragenen Signale isoliert durch das elektrisch leitende Halbleitersubstrat geführt werden müssen. Die induktive Signalübertragung kann deshalb besonders vorteilhaft bei Prozessen mit leitenden Substraten angewendet werden.

Die Ansprüche 2 bis 7 sind auf bevorzugte Ausbildungen der erfindungsgemäßen Vorrichtung gerichtet.

Die Erfindung wird nachfolgend anhand der Zeichnungen näher erläutert. Dabei zeigt
- Figur 1: eine Darstellung mehrerer Chiplagen einer vertikal integrierten Schaltung mit einer erfindungsgemäßen Anordnung ,
- Figur 2: ein vierfaches Zeit-Diagramm zur Erläuterung der Anordnung von Fig 1,
- Figur 3: ein Blockschaltbild einer Sendeeinrichtung einer erfindungsgemäßen Anordnung,
- Figur 4: ein detailiertes Schaltbild einer Sendeeinrichtung nach Figur 3,
- Figur 5: ein Prinzipschaltbild einer ersten Ausführungsform einer Empfangseinrichtung einer erfindungsgemäßen Anordnung,
- Figur 6: ein detailiertes Schaltbild einer Empfangseinrichtung nach dem Funktionsprinzip von Figur 5,
- Figur 7: ein Prinzipschaltbild einer zweien Ausführungsform einer Empfangseinrichtung einer erfindungsgemäßen Anordnung und
- Figur 8: ein detailiertes Schaltbild einer Empfangseinrichtung nach dem Funktionsprinzip von Figur 7.

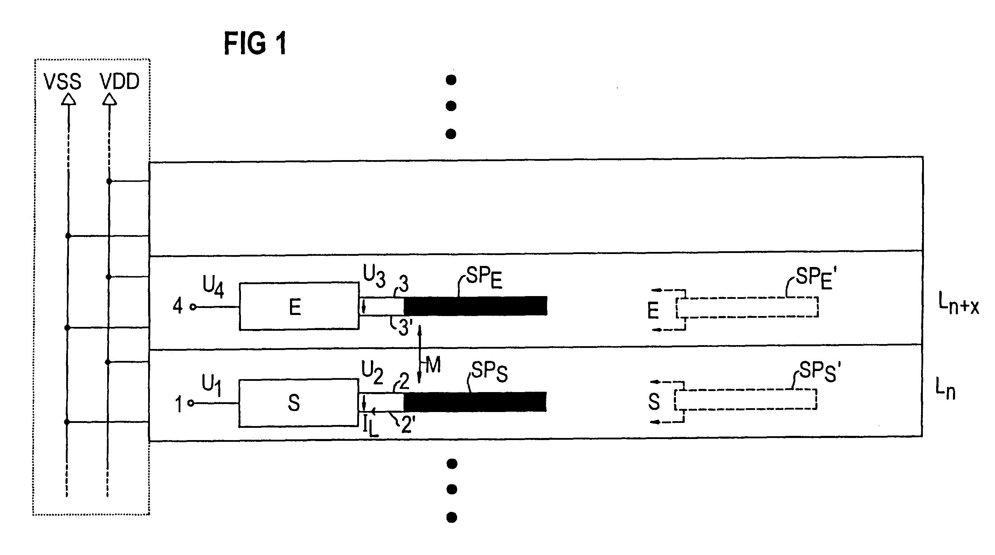

In Figur 1 sind drei Chiplagen stellvertretend für eine Vielzahl von Chiplagen einer VIC dargestellt, wobei in einer Chiplage Lₙ eine Sendeeinrichtung S und in einer weiteren Chiplage Lₙ₊ₓ eine Empfangseinrichtung E vorgesehen sind. Die drei Chiplagen sind hierbei jeweils mit den Versorgungsspannungen VDD und VSS versorgt. Die Sendeeinrichtung S weist einen Eingang 1 auf, an dem eine Spannung U₁ anliegt und weist zwei Ausgänge 2 und 2' auf, zwischen denen eine Spannung U₂ ansteht. Die beiden Ausgänge 2 und 2' sind mit Eingängen einer Sendespule SP_{S} in der Chiplage Lₙ verbunden und durch die Sendespule SP_{S} fließt ein Spulenstrom I_{L}. Die in der Chiplage Lₙ₊ₓ befindliche Empfangseinrichtung E weist zwei Eingänge 3 und 3' auf zwischen denen eine Spannung U₃ anliegt und die mit den Eingängen einer Empfangsspule SP_{E} verbunden sind. Ferner weist die Empfangseinrichtung E einen Ausgang 4 auf, an dem eine Spannung U₄ anliegt. Die beiden Spulen SP_{S} und SP_{E} sind über eine Koppelinduktivität M miteinander induktiv verkoppelt, wodurch eine Signalübertragung aus der Chiplage Lₙ in die Chiplage Lₙ₊ₓ erfolgt.

Für die Erfindung ist es unwesentlich, ob dabei die Sendeeinrichtung in der Chiplage Lₙ oder in der weiteren Chiplage Lₙ₊ₓ bzw. die Empfangseinrichtung E in der Chiplage Lₙ oder in der Chiplage Lₙ₊ₓ liegt.

In Figur 1 sind die beiden Spulen SP_{E} und SP_{S} in benachbarten Chiplagen dargestellt, dies ist jedoch nicht zwingend erforderlich, was durch die Chiplagenbezeichnung Lₙ₊ₓ angedeutet ist. Der Kopplungsgrad der beiden Spulen nimmt jedoch mit zunehmendem Abstand der Spulen ab, kann aber beispielsweise durch zwischen den Spulen eventuell in dazwischenliegenden Chiplagen eingebrachte Bereiche mit hoher magnetischer Permeabilität wiederum erhöht werden.

Darüber hinaus sind in der Figur 1 in der Chiplage Ln eine optional vorgesehene weitere Sendespule SP'_{S} und in der Chiplage Lₙ₊ₓ eine weitere Empfangsspule SP_{E}' gestrichelt eingezeichnet und Verbindungen der weiteren Sendespule mit der Sendeeinrichtung S sowie Verbindungen der weiteren Empfangsspule mit der Empfangseinrichtung E ebenfalls gestrichelt angedeutet. Durch die Sendespulen SP_{S} und SP'_{S} können zueinander komplementäre Signale gesendet und durch Spulen SP_{E} und SP'_{E} empfangen werden und in einer entsprechenden Empfangseinheit differentiell ausgewertet werden. Der Vorteil hierbei besteht darin, daß in die Spulen eingekoppelte Störungen auf die Empfangs spulen weitgehend gleich einwirken und durch die differentielle Auswertung der Gleichtaktanteil, also die Störgröße, praktisch völlig unterdrückt wird.

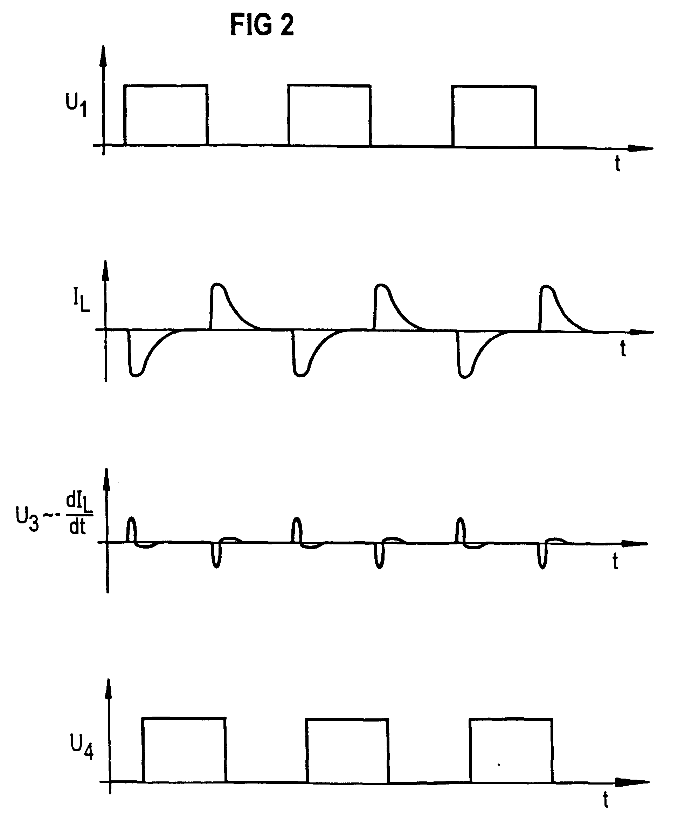

In Figur 2 sind vier Zeitdiagramme dargestellt, wobei im ersten Zeitdiagramm die rechteckförmige Spannung U₁, im zweiten Diagramm der Spulenstrom I_{L}, im dritten Diagramm die Eingangsspannung U₃ an der Empfangseinrichtung E und im vierten Zeitdiagramm die rechteckförmige Ausgangsspannung U₄ dargestellt sind, wobei sich die Ausgangsspannung U₄ im allgemeinen nur durch eine zeitliche Verschiebung und um einen konstanten Faktor von der rechteckförmigen Eingangsspannung U₁ unterscheidet. Der Spulenstrom I_{L} zeigt dabei einen starken Abfall mit der steigenden Flanke der Spannung U₁ und steigt daraufhin von seinem Minimalwert ungefähr exponentiell auf Null an bis, durch eine negative Flanke der Spannung U₁ ein steiler Anstieg des Spulenstroms I_{L} und ebenfalls ein nachfolgender ungefähr exponentieller Rückgang auf den Wert Null erfolgt. Die Spannung U₃ ist dabei proportional zum Differenzialquotienten -dI_{L}/dt, was zum ungefähren Zeitpunkt der ansteigenden Flanken der Spannung U₁ zu einem kurzen positiven Anstieg bzw. bei jeder negativen Flanke der Spannung U₁ zu einem negativen Impuls bei der Spannung U₃ führt. Die Spannung U₄ wird zum ungefähren Zeitpunkt des positiven Impulses der Spannung U₃ auf den maximalen Wert der Spannung U₄ und durch den negativen Impuls der Spannung U₃ auf den minimalen Wert der Spannung U₄ geschaltet.

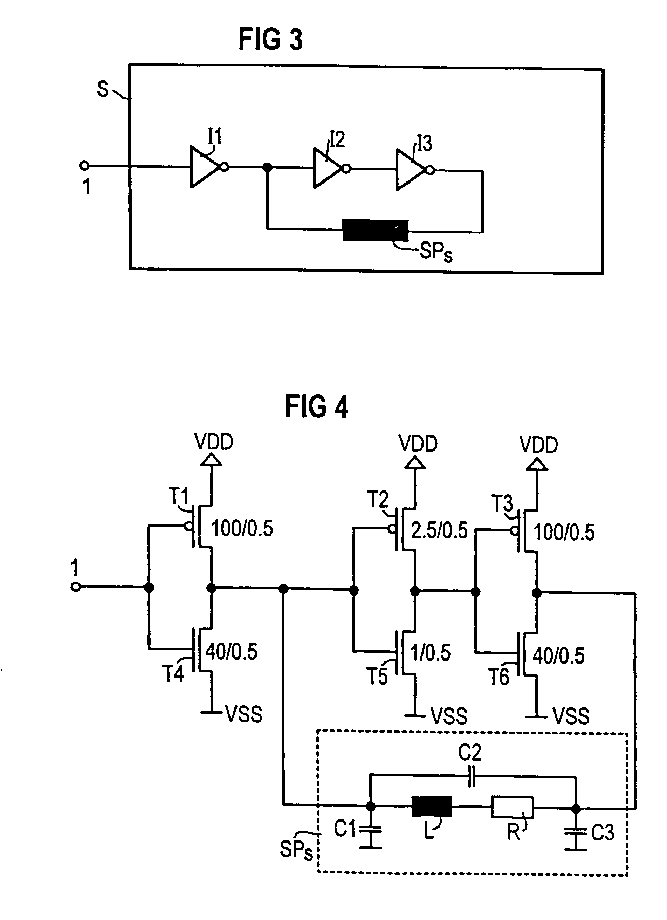

In Figur 3 ist ein Ausführungsbeispiel für die Sendeeinrichtung S, bestehend aus drei Invertern I1...I3 und der Sendespule SP_{S} dargestellt. Der Eingang 1 ist dabei über den Inverter I1 mit dem Eingang des Inverters I2 verbunden. Zur Informationsübertragung wird die Spendespule bei jeder Signalflanke von einem kurzen Strompuls entsprechender Polarität mit steiler Anstiegsflanke und flach abfallendem Verlauf durchflossen. Dies wird durch die in Figur 3 dargestellte Sendeeinrichtung S infolge von Laufzeiteffekten durch die in Reihe geschalteten Inverter I2 und I3 erreicht.

Die Koppelinduktivität M in Figur 1 wird durch übereinander angeordnete Spiralen in den Metallisierungsebenen der kommunizierenden Chiplagen hergestellt. Dabei können die einzelnen Spulen durch Windungen in einer oder mehreren Ebenen realisiert werden. Zur Minimierung parasitärer Kapazitäten bietet sich, bei einer Realisierung in mehreren Ebenen, eine versetzte Anordnung der Metallbahnen in den jeweiligen Verdrahtungsebenen an. Die Induktivität bildet mit der parasitären Kapazität und dem Innenwiderstand der Spule einen parasitären LCR-Schwingkreis. Der Innenwiderstand von Sender- und Empfängerspulen muß so gewählt werden, daß der LCR-Schwingkreis aperiodisches Verhalten aufweist.

Figur 4 zeigt eine Ausführungsform der Sendeeinrichtung S, wobei drei p-Kanal-Feldeffekttransistoren T1...T3 und drei n-Kanal-Transitoren T4...T6 vorgesehen sind und wobei die Transistoren T1 und T4 den ersten Inverter I1, die Transistoren T2 und T5 den zweiten Inverter I2 und die Transistoren T3 und T6 den dritten Inverter I3 bilden. Die Inverterstufen sind jeweils mit den Versorgungsspannungen VDD und VSS versorgt. Die in Figur 3 dargestellte Sendespule SP_{S} ist in Figur 4 durch das Ersatzschaltbild in Form einer überbrückten π-Schaltung ersetzt. Das Ersatzschaltbild weist dabei eine Induktivität L und einen dazu in Reihe geschalteten Widerstand R auf, die durch eine parasitäre Kapazität C₂ überbrückt sind und wobei die beiden Enden der Reihenschaltung aus der Induktivität L und des Widerstandes R über parasitäre Kapazitäten C₁ und C3 mit Massepotential VSS verbunden sind. Die aus den Transistoren T1 und T4 und den Transistoren T3 und T6 gebildeten Inverter I1 und I3 steuern die Sendespule an. Über die Flankensteilheit des am Eingang 1 anliegenden Sendeeingangssignals und die Dimensionierung des Inverters I1 läßt sich die Steilheit der ansteigenden Flanken der Stromimpulse des Spulenstroms I_{L} steuern. Die fallende Flanke der Stromimpulse und damit auch deren Dauer wird über die Inverter I2 und I3 eingestellt. Da die Spule immer nur kurzzeitig durch den Strom I_{L} durchflossen wird, verbraucht der Sender statisch keine Leistung.

Die Kanalweiten der Transistoren T1...T6 in der Sendeeinrichtung S betragen hierbei beispielsweise der Reihe nach 100 µm, 2,5 µm, 100 µm, 40 µm, 1 µm und 40 µm und die Kanallängen der Transistoren T1...T6 betragen jeweils 0,5 µm.

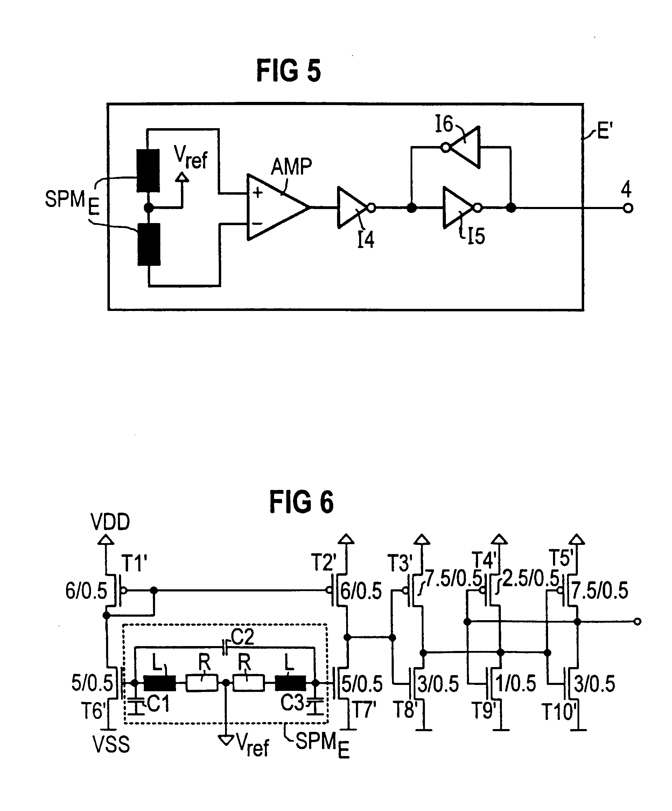

In Figur 5 ist ein Prinzipschaltbild einer ersten Ausführungsform E' der Empfangseinrichtung E dargestellt. Die Empfangseinrichtung E' enthält dabei eine Empfangsspule SPM_{E} mit Mittenanzapfung, wobei die Mittenanzapfung mit einem Referenzpotential V_{ref} verbunden ist. Der nicht mit dem Referenzpotential verbundene Anschluß eines ersten Teiles der Spule SPM_{E} ist mit dem nicht invertierenden Eingang eines Verstärkers AMP und der nicht mit dem Referenzpotential verbundene Anschluß des zweiten Teiles der Spule SPM_{E} ist mit dem invertierenden Eingang des Differenzverstärkers AMP verbunden, dessen Ausgang über einen Inverter I4 mit dem Eingang eines Inverters I5 und dem Ausgang eines Inverters I6 verbunden ist. Die Inverter I5 und I6 sind dabei antiparallel geschaltet und bilden ein Halteglied, wobei der Ausgang des Inverters I5 und der Eingang des Inverters I6 mit dem Ausgang 4 der Empfangseinrichtung E' verbunden ist.

In Figur 6 ist eine konkrete Ausgestaltung der Empfangseinrichtung E' mit fünf p-Kanal-Transistoren T1'...T5' und fünf n-Kanaltransistoren T6'...T10' und mit dem Ersatzschaltbild der Spule SPM_{E} mit Mittelanzapfung dargestellt. Die Transistoren T1' und T6' sowie die Transistoren T2' und T7' bilden jeweils Zweige des Differenzverstärkers AMP, wobei jeweils ein Anschluß des Transistors T1' und T2' mit der Versorgungsspannung VDD und ein Anschluß der Transistoren T6' und T7' mit der Versorgungsspannung VSS verbunden ist. Die Gateanschlüsse der Transistoren T1' und T2' sind mit dem Verbindungsknoten der beiden Transistoren T1' und T6' verbunden. Das Ersatzschaltbild der Spule SPM_{E} besteht für jeden Teil der Spule jeweils aus einer Induktivität L und einem dazu in Reihe geschalteten Serienwiderstand R der Spule, wobei beide Induktivitäten und Innenwiderstände durch eine parasitäre Kapazität C₂ überbrückt sind. Die Enden der überbrückten Reihenschaltung sind mit den Eingängen des Differenzverstärkers beschaltet, die den Gateanschlüssen der Transistoren T6' und T7' entsprechen und die über parasitäre Kapazitäten C₁ und C₃ des Ersatzschaltbildes der Spule SPM_{E} mit dem Massepotential VSS verbunden sind . Die Transistoren T3' und T8' bilden den Inverter I4, die Transistoren T5' und T6' den Inverter I5' und die Transistoren T4' und T9' den Inverter I6.

Die Kanalweiten der Transistoren T1'...T10' können hierbei beispielsweise der Reihe nach 6 µm, 6 µm, 7,5 µm, 2,5 µm, 7,5 µm, 5 µm, 5 µm, 3 µm, 1 µm und 3 µm gewählt werden. Die Kanallängen der Transistoren T1'...T10' können beispielsweise jeweils 0,5 µm gewählt werden.

Die bei Empfang eines Sendeimpulses in den beiden Teilspulen gegensinnig induzierte Spannung wird durch die Differenzverstärkerstufe verstärkt. Der aus den Transistoren T3' und T8' Inverter I4 dient der weiteren Verstärkung des Signals und der Entkopplung der Differenzverstärkerstufe AMP und dem aus den Invertern I5 und I6 bestehenden Halteglied. Die verstärkten Impulse werden dabei durch das Halteglied in statische CMOS-Pegel umgewandelt.

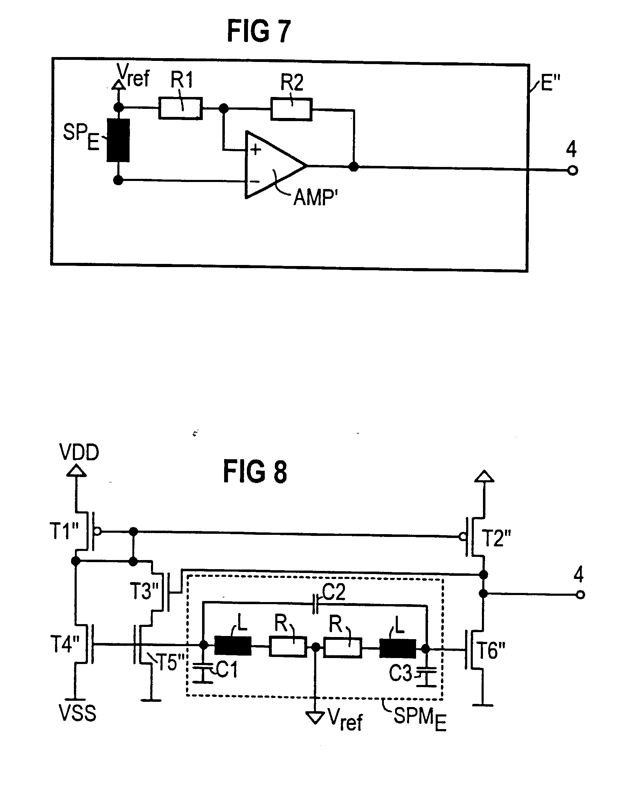

Figur 7 zeigt ein Prinzipschaltbild einer weiteren Ausführungsform E'' der Empfangseinheit E, bei der eine einseitig mit einem Referenzpotential V_{ref} verbundene Spule SP_{E} mit ihrem nicht mit der Referenzspannung verbundenen Anschluß mit dem invertierenden Eingang eines Differenzverstärkers AMP' verbunden ist. Der nicht invertierende Eingang der Differenzverstärkerstufe AMP' ist hierbei über einen Widerstand R1 mit dem Referenzpotential V_{ref} und einem Anschluß der Spule beschaltet und es besteht für einen Widerstand R2 eine Rückkopplung des Ausgangs auf den nicht invertierenden Eingang des Differenzverstärkers AMP', was einer Mitkopplung entspricht, die ein Hystereseverhalten des Differenzverstärkers AMP' bewirkt. Der Ausgang des Differenzverstärkers AMP' ist über einen Inverter I7 mit dem Ausgang 4 der Empfangseinrichtung E'' verbunden.

In Figur 8 ist eine detaillierte Schaltung einer Empfangseinrichtung E'' nach Figur 7 dargestellt und enthält zwei p-Kanal-Transistoren T1'' und T2''sowie vier n-Kanal-Transistoren T3''...T6'' und eine Ersatzschaltung für eine Spule SPM_{E} mit Mittenanzapfung, wie sie in Figur 5 bzw. Figur 6 näher beschrieben ist. Die Transistoren T1'' und T4'' sowie die Transistoren T2'' und T6'' sind jeweils paarweise in Reihe geschaltet und liegen zwischen den Versorgungsspannungen VDD und VSS, wobei die Gateanschlüsse der Transistoren T1'' und T2'' mit dem Verbindungspunkt zwischen den beiden Transistoren T1'' und T4'' beschaltet sind. Der Verbindungspunkt zwischen den Transistoren T1'' und T4'' ist über eine Reihenschaltung aus den Transistoren T3'' und T5'' mit der Versorgungsspannung VSS verbunden, wobei der Gateanschluß des Transistors T3'' mit dem Verbindungspunkt zwischen den Transistoren T2'' und T6'', der gleichzeitig den Ausgang 4 darstellt, verbunden ist und wobei die Gateanschlüsse der Transistoren T4'' und T5'' mit einem Ende der Spule SPM_{E} und der Gateanschluß des Transistors T6'' mit dem anderen Ende der Spule SPM_{E} verbunden ist. Die Umwandlung der übertragenen Spannungsimpulse in statische Signale wird hier durch eine Hysterese in der Komparatorschaltung gewährleistet. Die Transistoren T4'', T5'' und T6'' sind im statischen Betrieb im Prinzip als Stromquellen geschaltet. Die Transistoren T1'' und T2'' bilden einen Stromspiegel. Die Hysterese wird durch Ein- und Ausschalten der durch den Transistor T5 gebildeten Stromquelle in Abhängigkeit des Ausgangssignals realisiert, wobei bei einem Low-Pegel am Ausgang 4 der Transistor T3 gesperrt ist und somit der zum Transistor T2 gespiegelte Strom so klein ist, daß der Transistor T6'' im linearen Bereich mit kleiner Drain-Source-Spannung betrieben wird, wodurch der Ausgangspegel am Ausgang 4 klein bleibt. Entsprechenderweise wird auch ein High-Pegel am Ausgang 4 gehalten. Wird ein Signalpuls übertragen, so löst der in der Empfängerspule SPM_{E} generierte Spannungsimpuls einen Kippvorgang in der Empfangseinrichtung aus.

Das Referenzpotential V_{ref} in den beiden Empfangseinrichtungen E' und E'' kann beispielsweise in einer Gleichspannung von ca. 1 Volt bestehen und beispielsweise durch einen Stromspiegel realisiert werden.

Die Funktion der Schaltungen wurde für Koppelinduktivitäten bis hinunter zu 5 nH und die Frequenzen von über 200 MHz durch Simulation verifiziert.

## Patentansprüche

1. Anordnung zur Signalübertragung zwischen Chiplagen einer vertikal integrierten Schaltung ,
bei der eine Koppelinduktivität (M) zur definierten induktiven Signalübertragung zwischen einem Teil der Schaltung in einer Chiplage (Lₙ) und einem weiteren Teil der Schaltung in einer weiteren Chiplage (Lₙ₊ₓ) vorgesehen ist,
bei der in der weiteren Chiplage (Lₙ₊ₓ) eine Empfangseinrichtung (E) und in der Chiplage (Lₙ) eine Sendeeinrichtung (S) vorgesehen sind, die über die Koppelinduktivität (M) miteinander verkoppelt sind,
bei der die Koppelinduktivität (M) durch eine lateral ausgebildete Sendespule (SP_{S}) und eine lateral ausgebildete Empangsspule (SP_{E}) gebildet ist, wobei die Sendespule (SP_{S}) einen Bestandteil der Chiplage (Lₙ) und die Empfangs spule (SP_{E}) einen Bestandteil der weiteren Chiplage (Lₙ₊ₓ) bildet und
bei der die Chiplage (Lₙ) zusätzlich eine weitere lateral ausgebildete Sendespule (SP'_{S}) aufweist, die weitere Chiplage (Lₙ₊ₓ) eine weitere lateral ausgebildete Empfangsspule (SP'_{E}) aufweist,
bei der zusätzlich zum regulären Signal, das von der Sendespule (SP_{S}) zur Empfangsspule (SP_{E}) zu übertragen ist, von der weiteren Sendespule (SP_{S}') zur weiteren Empfangsspule (SP_{E}') ein zum regulären Signal komplementäres Signal zu übertragen ist und
bei der sowohl das reguläre als auch das komplementäre Signal in der Empfangseinrichtung (E) differentiell ausgewertet sind.

2. Anordnung nach Anspruch 1,
bei der die Sendeeinrichtung (S) eine Signalverzögerungeinheit (I2,I3) und eine Sendespule (SP_{S}) aufweist.

3. Anordnung nach Anspruch 1,
bei der die Empfangseinrichtung (E') als Komparator mit mit nachgeschalteten Halteglied ausgebildet ist und an seinen Eingängen mit der Empfangsspule (SP_{E}) verbunden ist.

4. Anordnung nach Anspruch 1,
bei der die Empfangseinrichtung (E") als Komparator mit Hysterese ausgebildet und an seinen Eingängen mit der Empfangsspule (SP_{E}) verbunden ist.

## Claims

1. Arrangement for signal transfer between chip layers of a vertically integrated circuit,
in which provision is made of a coupling inductance (M) for the defined inductive signal transfer between one part of the circuit in a chip layer (Lₙ) and a further part of the circuit in a further chip layer (Lₙ₊ₓ),
in which a receiving device (E) is provided in the further chip layer (Lₙ₊ₓ) and a transmitting device (S) is provided in the chip layer (Lₙ), which devices are coupled to one another via the coupling inductance (M),
in which the coupling inductance (M) is formed by a laterally designed transmitting coil (SP_{S}) and a laterally designed receiving coil (SP_{E}), the transmitting coil (SP_{S}) forming a constituent of the chip layer (Lₙ) and the receiving coil (SP_{E}) forming a constituent of the further chip layer (Lₙ₊ₓ), and
in which the chip layer (Lₙ) additionally has a further laterally designed transmitting coil (SP'_{S}), and the further chip layer (Lₙ₊ₓ) has a further laterally designed receiving coil (SP'_{E}),
in which, in addition to the regular signal which is to be transferred from the transmitting coil (SP_{S}) to the receiving coil (SP_{E}), a signal which is complementary with respect to the regular signal is to be transmitted from the further transmitting coil (SP_{S},) to the further receiving coil (SP_{E'}), and
in which both the regular and the complementary signal are evaluated differentially in the receiving device (E).

2. Arrangement according to Claim 1,
in which the transmitting device (S) has a signal delay unit (I2, I3) and a transmitting coil (SP_{S}).

3. Arrangement according to Claim 1,
in which the receiving device (E') is designed as a comparator with a holding element connected downstream and, at its inputs, is connected to the receiving coil (SP_{E}).

4. Arrangement according to Claim 1,
in which the receiving device (E") is designed as a comparator with hysteresis and, at its inputs, is connected to the receiving coil (SP_{E}).

## Revendications

1. Dispositif de transfert de signaux entre les couches de puce d'un circuit intégré vertical,
dans lequel une inductance de couplage (M) pour le transfert inductif défini de signaux est prévue entre une partie du circuit dans une couche de puce (Lₙ) et une autre partie du circuit dans une autre couche de puce (Lₙ₊ₓ),
dans lequel un dispositif de réception (E) est prévu dans l'autre couche de puce (Lₙ₊ₓ) et un dispositif d'émission (S) dans la couche de puce (Lₙ), lesquels dispositifs étant couplés entre eux via l'inductance de couplage (M),
dans lequel l'inductance de couplage (M) est formée par une bobine d'émission (SP_{S}) de réalisation latérale et une bobine de réception (SP_{E}) de réalisation latérale, la bobine d'émission (SP_{S}) formant un élément de la couche de puce (Lₙ) et la bobine de réception (SP_{E}) formant un élément de l'autre couche de puce (Lₙ₊ₓ), et dans lequel la couche de puce (Lₙ) comporte en plus une autre bobine d'émission (SP'_{S}) de réalisation latérale et l'autre couche de puce (Lₙ₊ₓ) une autre bobine de réception (SP'_{E}) de réalisation latérale,
dans lequel, en plus du signal régulier à transférer de la bobine d'émission (SP_{S}) à la bobine de réception (SP_{E}), un signal complémentaire au signal régulier est à transférer de l'autre bobine d'émission (SP'_{S}) à l'autre bobine de réception (SP'_{E}) et
dans lequel le signal régulier de même que le signal complémentaire sont analysés de façon différentielle dans le dispositif de réception (E).

2. Dispositif selon la revendication 1, dans lequel le dispositif d'émission (S) comporte une unité de retardement du signal (I2, I3) et une bobine d'émission (SP_{S}).

3. Dispositif selon la revendication 1, dans lequel le dispositif de réception (E') se présente sous forme de comparateur muni d'un organe de maintien monté en aval et est relié à ses entrées à la bobine de réception (SP_{E}).

4. Dispositif selon la revendication 1, dans lequel le dispositif de réception (E'') se présente sous forme de comparateur à hystérèse et est relié à ses entrées à la bobine de réception (SP_{E}).
